(19) Europäisches Patentamt
European Patent Office
Office européen des brevets

(11) **EP 4 527 992 A2**

(12) **EUROPEAN PATENT APPLICATION**

(43) Date of publication:
26.03.2025 Bulletin 2025/13

(21) Application number: 24196716.5

(22) Date of filing: 27.08.2024

(51) International Patent Classification (IPC):
**C30B 23/06** $^{(2006.01)}$ **C30B 29/36** $^{(2006.01)}$
**C30B 33/06** $^{(2006.01)}$

(52) Cooperative Patent Classification (CPC):
**C30B 29/36; C30B 23/063; C30B 33/06**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.08.2023 JP 2023141660**

(71) Applicant: **Resonac Corporation**
**Tokyo 105-7325 (JP)**

(72) Inventors:
• **TAJIMA, Mitsuki**
**Tokyo, 105-7325 (JP)**
• **SUO, Hiromasa**
**Tokyo, 105-7325 (JP)**

(74) Representative: **Strehl & Partner mbB**
**Maximilianstrasse 54**
**80538 München (DE)**

(54) **SIC SINGLE CRYSTAL BOULE, MANUFACTURING METHOD OF SIC SINGLE CRYSTAL BOULE, AND MANUFACTURING METHOD OF SIC SUBSTRATE**

(57) A SiC single crystal boule according to the present embodiment includes a portion in a cross section orthogonal to a crystal growth direction in which a line segment passing through a center of a largest inscribed circle contained within the cross section and connecting a first outer circumferential point and a second outer circumferential point of the cross section has a length of 211 mm or more and 221 mm or less.

FIG. 1

EP 4 527 992 A2

## Description

BACKGROUND

Field

The present disclosure relates to a SiC single crystal boule, a manufacturing method of the SiC single crystal boule, and a manufacturing method of a SiC substrate.

Description of Related Art

Silicon carbide (SiC) has a dielectric breakdown electric field that is an order of magnitude larger than that of silicon (Si) and a band gap that is three times larger than that of silicon (Si). Also, silicon carbide (SiC) has characteristics such as a thermal conductivity that is about three times higher than that of silicon (Si). Therefore, silicon carbide (SiC) is expected to be applied to power devices, high-frequency devices, high-temperature operation devices, and the like. For this reason, in recent years, SiC epitaxial wafers have come to be used in such semiconductor devices described above.
A SiC epitaxial wafer is obtained by laminating a SiC epitaxial layer on a surface of a SiC substrate. Hereinafter, a substrate before the SiC epitaxial layer is laminated thereon is referred to as the SiC substrate, and a substrate after the SiC epitaxial layer is laminated thereon is referred to as the SiC epitaxial wafer. SiC devices such as power devices, high-frequency devices, and high-temperature operation devices are obtained by forming devices on the SiC epitaxial layer of the SiC epitaxial wafer and then dicing the SiC epitaxial wafer into chips.
The SiC substrate is obtained by slicing a SiC ingot. The SiC ingot is a single crystal processed into a cylindrical shape, and is obtained by processing a SiC single crystal boule. In order to improve production efficiency, it is necessary to obtain a large number of SiC substrates from one SiC single crystal boule.
For example, Patent Document 1 discloses a method for producing a large number of Si wafers at a time by producing a large-diameter silicon single crystal ingot and dividing the silicon single crystal ingot.

[Patent Documents]

[Patent Document 1] Japanese Unexamined Patent Application, First Publication No. 2002-75923

SUMMARY OF THE INVENTION

A SiC single crystal is formed by bonding Si and C elements, and is more difficult to manufacture than a Si single crystal consisting solely of a Si element. As described in Patent Document 1, a method of dividing a large-diameter single crystal in a radial direction is useful, but in a case of SiC, it is extremely difficult to produce a large-diameter SiC single crystal boule in the first place. When attempting to produce a large-diameter SiC single crystal boule, a stress occurring within the SiC single crystal boule increases, causing the SiC single crystal boule to crack.
The present disclosure has been made in view of the above-described problems, and an objective of the present disclosure is to provide a SiC single crystal boule from which a large number of SiC substrates can be efficiently obtained.
The present inventors have found a method of producing a large-diameter SiC single crystal boule, and determined a size of the SiC single crystal boule suitable for obtaining a plurality of SiC substrates from the same plane.

(1) A SiC single crystal boule according to a first aspect includes a portion in a cross section orthogonal to a crystal growth direction in which a line segment passing through a center of a largest inscribed circle contained within the cross section and connecting a first outer circumferential point and a second outer circumferential point of the cross section has a length of 211 mm or more and 221 mm or less.
(2) In the SiC single crystal boule according to the above described aspect, a length of the line segment may be 214 mm or more and 218 mm or less.
(3) A SiC single crystal boule according to a second aspect includes a portion in a cross section orthogonal to a crystal growth direction in which a line segment passing through a center of a largest inscribed circle contained within the cross section and connecting a first outer circumferential point and a second outer circumferential point of the cross section has a length of 236 mm or more and 248 mm or less.
(4) In the SiC single crystal boule according to the above described aspect, a length of the line segment may be 240 mm or more and 244 mm or less.
(5) A SiC single crystal boule according to a third aspect includes a portion in a cross section orthogonal to a crystal growth direction in which a line segment passing through a center of a largest inscribed circle contained within the cross section and connecting a first outer circumferential point and a second outer circumferential point of the cross section has a length of 319 mm or more and 329 mm or less.

(6) In the SiC single crystal boule according to the above described aspect, a length of the line segment may be 322 mm or more and 326 mm or less.

(7) A SiC single crystal boule according to a fourth aspect includes a portion in a cross section orthogonal to a crystal growth direction in which a line segment passing through a center of a largest inscribed circle contained within the cross section and connecting a first outer circumferential point and a second outer circumferential point of the cross section has a length of 357 mm or more and 368 mm or less.

(8) In the SiC single crystal boule according to the above described aspect, a length of the line segment may be 361 mm or more and 365 mm or less.

(9) A manufacturing method of a SiC single crystal boule according to a fifth aspect includes a crystal growth step of growing a SiC single crystal on a first surface of a seed crystal using a sublimation method, in which laser is emitted onto a second surface of the seed crystal on a side opposite to the first surface while the seed crystal is rotated in the crystal growth step, and a temperature of a laser irradiation position is controlled to be within $\pm 5°C$ of a temperature at a center of the seed crystal in a radial direction.

(10) A manufacturing method of a SiC substrate according to a sixth aspect includes a step of forming an opening at a center of the SiC single crystal boule according to the above-described aspect, a step of cutting the SiC single crystal boule radially outward from the opening and dividing the SiC single crystal boule into a plurality of parts, and a step of processing each of the plurality of parts into a SiC ingot and slicing the SiC ingot.

A large number of SiC substrates can be efficiently obtained from the SiC single crystal boule according to the above-described aspect.

BRIEF DESCRIPTION OF THE DRAWINGS

FIG. 1 is a cross-sectional view of a SiC single crystal boule according to a first embodiment.

FIG. 2 is a cross-sectional view of the SiC single crystal boule according to the first embodiment taken along an XY plane orthogonal to a Z direction.

FIG. 3 is an XY cross section illustrating a first example of a case in which a plurality of SiC ingots are obtained from the SiC single crystal boule according to the first embodiment.

FIG. 4 is an XY cross section illustrating a second example of a case in which a plurality of SiC ingots are obtained from the SiC single crystal boule according to the first embodiment.

FIG. 5 is a view for explaining a manufacturing method of the SiC single crystal boule according to the first embodiment.

FIG. 6 is a view for explaining a manufacturing method of a SiC substrate according to the first embodiment.

FIG. 7 is a view for explaining a manufacturing method of the SiC substrate according to the first embodiment.

FIG. 8 is a view for explaining a manufacturing method of the SiC substrate according to the first embodiment.

FIG. 9 is a view for explaining a manufacturing method of the SiC substrate according to the first embodiment.

DETAILED DESCRIPTION

Hereinafter, a SiC single crystal boule and a SiC substrate according to the present embodiment will be described in detail with reference to the drawings as appropriate. In the drawings used in the following description, there are cases in which characteristic portions are enlarged for convenience of illustration so that characteristics of the present embodiment can be easily understood, and dimensional proportions or the like of components may be different from actual ones. Materials, dimensions, and the like illustrated in the following description are merely examples, and the present disclosure is not limited thereto and can be implemented with appropriate modifications within a range not changing the gist of the present disclosure.

First, directions will be defined. A main direction of crystal growth of the SiC single crystal boule will be referred to as a Z direction. A thickness direction of s seed crystal is an example of the Z direction. Also, one radial direction of the SiC single crystal boule will be referred to as an X-direction. Also, one radial direction of the SiC single crystal boule that is orthogonal to the X direction will be referred to as a Y direction. The X and Y directions are orthogonal to the Z direction.

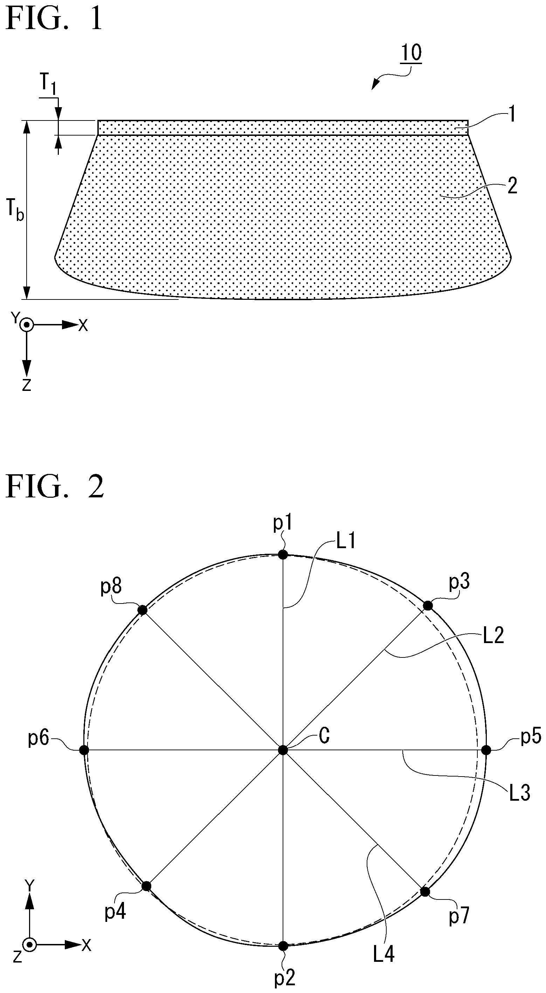

FIG. 1 is a cross-sectional view of a SiC single crystal boule 10 according to the present embodiment. The SiC single crystal boule 10 includes a seed crystal 1 and a crystal growth portion 2. The seed crystal 1 is a SiC single crystal serving as a starting point for crystal growth of the SiC single crystal boule 10. The crystal growth portion 2 is a SiC single crystal grown on the seed crystal 1.

The SiC single crystal boule 10 may be a p-type semiconductor, an n-type semiconductor, or an intrinsic semiconductor. The SiC single crystal boule 10 may have semi-insulating properties. A polytype of the SiC single crystal boule 10 is not particularly limited and may be any of 4H, 6H, 3C, and 15R, or may have a plurality of polytypes. An offset angle of the SiC single crystal boule 10 is, for example, 0 degrees or more and 8 degrees or less. The seed crystal 1 and the crystal growth portion 2 constituting the SiC single crystal boule 10 have the same conductivity type, polytype, and offset angle.

A thickness $T_b$ of the SiC single crystal boule 10 in the Z direction is 3 mm or more. The thickness $T_b$ of the SiC single crystal boule 10 in the Z direction is preferably 15 mm or more. When the thickness $T_b$ of the SiC single crystal boule 10 in the Z direction is 15 mm or more, dislocations in the vicinity of a facet can be swept out of a substrate acquisition region when the offset angle is 4 degrees. A thickness $T_1$ of the seed crystal 1 in the Z direction is, for example, 1 mm or less. A thickness $T_1$ of the seed crystal 1 in the Z direction is, for example, 0.35 mm or more.

FIG. 2 is a cross-sectional view of the SiC single crystal boule 10 according to the present embodiment taken along an XY plane orthogonal to the Z direction. The cross section of the SiC single crystal boule 10 taken in the XY plane is substantially circular. The cross section of the SiC single crystal boule 10 taken in the XY plane is almost never a perfect circle, and a diameter thereof has a certain degree of variation. For example, line segments L1, L2, L3, and L4 passing through a center C of the cross section are often different from each other. The line segment L1 passes through the center C of the cross section and connects a first outer circumferential point p1 and a second outer circumferential point p2. The line segment L2 is at a position obtained by rotating the line segment L1 by 45 degrees with respect to the center C, passes through the center C of the cross section, and connects a third outer circumferential point p3 and a fourth outer circumferential point p4. The line segment L3 is at a position obtained by rotating the line segment L1 by 90 degrees with respect to the center C, passes through the center C of the cross section, and connects a fifth outer circumferential point p5 and a sixth outer circumferential point p6. The line segment L4 is at a position obtained by rotating the line segment L1 by 135 degrees with respect to the center C, passes through the center C of the cross section, and connects a seventh outer circumferential point p7 and an eighth outer circumferential point p8. Lengths of the line segments L1, L2, L3, and L4 are each within ±1.0% of an average of the lengths of the line segments L1, L2, L3, and L4.

Here, the "center of the cross section" refers to a center of the cross section when viewed from a macroscopic point of view. If the cross section is irregular, a center of a largest inscribed circle contained within the cross section is the "center of the cross section". A shape of the cross section can be determined by measuring an outer diameter of the SiC single crystal boule 10 at a plurality of positions using a caliper. For example, positions at which the outer diameter is measured with a caliper include a <1-100> direction and a <11-20> direction. Also, the shape of the cross section can also be determined from results obtained by measuring an overall shape of the single crystal boule using a three-dimensional measuring device.

A length of the line segment L1 is, for example, 211 mm or more and 221 mm or less, and preferably 214 mm or more and 218 mm or less. The line segment L1 can be set to any line segment that passes through the center C, and positions of the first outer circumferential point p1 and the second outer circumferential point p2 are arbitrary. That is, the line segment L1 having the length of 211 mm or more and 221 mm or less can be rephrased to say that the cross section of the SiC single crystal boule 10 includes a portion in which the length of the line segment L1 is 211 mm or more and 221 mm or less. Lengths of the line segments L2, L3, and L4 may be different from that of the line segment L1 and may be less than 211 mm or more than 221 mm. The lengths of the line segments L2, L3, and L4 are preferably 211 mm or more. The lengths of the line segments L2, L3, and L4 are preferably 221 mm or less.

Also, the length of the line segment L1 may be 236 mm or more and 248 mm or less, and preferably 240 mm or more and 244 mm or less. The cross section of the SiC single crystal boule 10 may include a portion in which the line segment L1 has a length of 236 mm or more and 244 mm or less, and preferably a portion in which the line segment L1 has a length of 240 mm or more and 244 mm or less. In this case, the lengths of the line segments L2, L3, and L4 may be different from that of the line segment L1 and may be less than 236 mm or more than 248 mm. The lengths of the line segments L2, L3, and L4 are preferably 236 mm or more. The lengths of the line segments L2, L3, and L4 are preferably 248 mm or less.

Also, the length of the line segment L1 may be 319 mm or more and 329 mm or less, and preferably 322 mm or more and 326 mm or less. The cross section of the SiC single crystal boule 10 may include a portion in which the line segment L1 has a length of 319 mm or more and 329 mm or less, and preferably a portion in which the line segment L1 has a length of 322 mm or more and 326 mm or less. The lengths of the line segments L2, L3, and L4 in this case may be different from that of the line segment L1 and may be less than 319 mm or more than 329 mm. The lengths of the line segments L2, L3, and L4 are preferably 319 mm or more. The lengths of the line segments L2, L3, and L4 are preferably 329 mm or less.

Also, the length of the line segment L1 may be 357 mm or more and 368 mm or less, and preferably 361 mm or more and 365 mm or less. The cross section of the SiC single crystal boule 10 may include a portion in which the line segment L1 has a length of 357 mm or more and 368 mm or less, and preferably a portion in which the line segment L1 has a length of 361 mm or more and 365 mm or less. The lengths of the line segments L2, L3, and L4 in this case may be different from that of the line segment L1 and may be less than 357 mm or more than 368 mm. The lengths of the line segments L2, L3, and L4 are preferably 357 mm or more. The lengths of the line segments L2, L3, and L4 are preferably 368 mm or less.

The cross section is, for example, any of a plane at an uppermost end, a plane at a lowermost end, a plane with a maximum diameter, and a plane with a minimum diameter. A direction of the line segment L1 is preferably, for example, a <11-20> direction or a <1-100> direction.

If the SiC single crystal boule 10 has the line segment L1 of a predetermined length, a plurality of SiC ingots can be efficiently obtained from one XY plane.

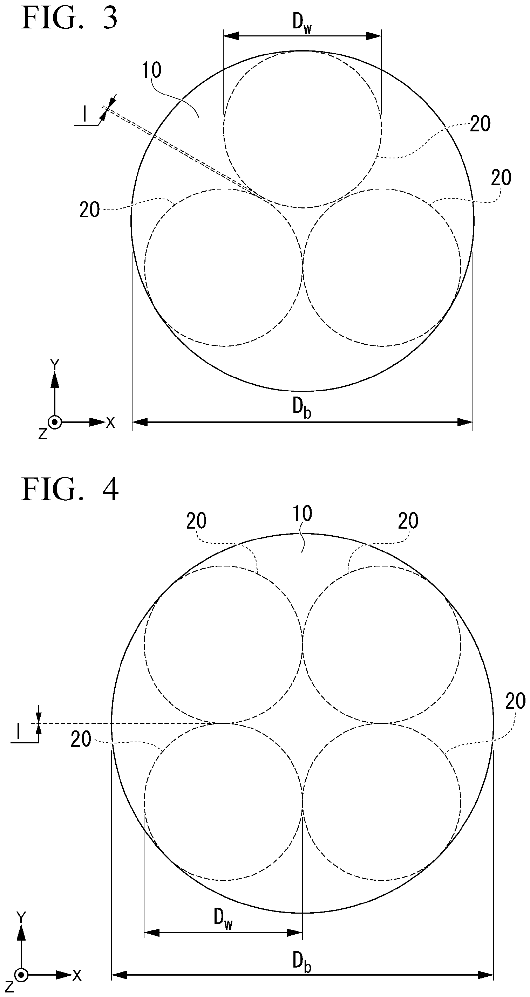

FIG. 3 is an XY cross section illustrating an example of a case in which a plurality of SiC ingots 20 are obtained from the SiC single crystal boule 10. FIG. 3 is a first example of a definition method for defining a required diameter $D_b$ of the SiC single crystal boule 10. The first example illustrated in FIG. 3 defines the required diameter $D_b$ of the SiC single crystal boule 10 when three SiC ingots 20 are obtained from the SiC single crystal boule 10. In the first example, the required diameter $D_b$ of the SiC single crystal boule 10 is defined on the basis of the following illustrated (1).

[Math. 1]

$$D_b = \left(\frac{2}{3}(D_w + l)\cos\frac{\pi}{6} + \frac{D_w}{2}\right) \times 2 \quad \cdots \ (1)$$

In expression (1), $D_b$ is a diameter required for the SiC single crystal boule 10, $D_w$ is a diameter of the SiC substrate, and l is a processing loss width. The processing loss width is a margin that takes into account a loss to be incurred during processing when the SiC ingots 20 are obtained from the SiC single crystal boule 10. The processing loss width is at least about 0.1 mm and at most about 0.6 mm. Also, since the SiC substrate is obtained by slicing the SiC ingot 20, the diameter of the SiC substrate is substantially the same as a diameter of the SiC ingot 20.

For example, a case in which three 4-inch SiC substrates are obtained from the same plane of the SiC single crystal boule 10 is considered. The diameter $D_w$ of the 4-inch substrate may have some variation. The allowable diameter $D_w$ for the 4-inch substrate is 98.0 mm or more and 102.0 mm or less.

[Table 1]

| Substrate diameter $D_w$ (mm) | 98.0 | 100.2 | 102.0 |
|---|---|---|---|
| Processing loss l (mm) | 0.1 | 0.3 | 0.6 |
| Boule diameter $D_b$ (mm) | 211.28 | 216.25 | 220.47 |

Table 1 shows results in which the required diameter $D_b$ of the SiC single crystal boule 10 is determined by varying the diameter $D_w$ and a size of the processing loss l. When three 4-inch substrates are obtained from the same plane of the SiC single crystal boule 10, the required diameter $D_b$ of the SiC single crystal boule 10 is 211 mm or more and 221 mm or less. The diameter Db is preferably between 211.28 mm or more and 220.47 mm or less. If the SiC single crystal boule 10 includes a portion in which the line segment L1 has a length of 211 mm or more and 221 mm or less, three SiC ingots 20 can be obtained from one SiC single crystal boule 10. Also, if an allowable range for the diameter $D_w$ of the 4-inch substrate is 99.5 mm or more and 100.6 mm or less, the required diameter $D_b$ of the SiC single crystal boule 10 is 214 mm or more and 218 mm or less. In this case, if the SiC single crystal boule 10 includes a portion in which the line segment L1 has a length of 214 mm or more and 218 mm or less, three SiC ingots 20 can be obtained from one SiC single crystal boule 10.

Similarly, a case in which three 6-inch substrates are obtained from the same plane of the SiC single crystal boule 10 is considered. The diameter $D_w$ of the 6 inch substrate may have some variation. The allowable diameter $D_w$ for the 6-inch substrate is 148.0 mm or more and 152.0 mm or less.

[Table 2]

| Substrate diameter $D_w$ (mm) | 148.0 | 150.2 | 152.0 |
|---|---|---|---|
| Processing loss l (mm) | 0.1 | 0.3 | 0.6 |
| Boule diameter $D_b$ (mm) | 319.01 | 323.98 | 328.21 |

Table 2 shows results in which the required diameter $D_b$ of the SiC single crystal boule 10 is determined by varying the diameter $D_w$ and a size of the processing loss l. When three 6-inch substrates are obtained from the same plane of the SiC single crystal boule 10, the required diameter $D_b$ of the SiC single crystal boule 10 is 319 mm or more and 329 mm or less. The diameter Db is preferably between 319.01 mm or more and 328.21 mm or less. If the SiC single crystal boule 10 includes a portion in which the line segment L1 has a length of 319 mm or more and 329 mm or less, three SiC ingots 20 can be obtained from one SiC single crystal boule 10. Also, if an allowable range for the diameter $D_w$ of the 6-inch substrate is 149.5 mm or more and 150.6 mm or less, the required diameter $D_b$ of the SiC single crystal boule 10 is 322 mm or more and 326 mm or less. In this case, if the SiC single crystal boule 10 includes a portion in which the line segment L1 has a length of 322 mm or more and 326 mm or less, three SiC ingots 20 can be obtained from one SiC single crystal boule 10.

FIG. 4 is an XY cross section illustrating an example of a case in which a plurality of SiC ingots 20 are obtained from the SiC single crystal boule 10. FIG. 4 illustrates a second example of a definition method for defining the required diameter $D_b$ of the SiC single crystal boule 10. In the second example illustrated in FIG. 4, the diameter $D_b$ of the SiC single crystal boule 10 is defined so that four SiC ingots 20 can be obtained from the SiC single crystal boule 10. In the second example, the diameter $D_b$ of the SiC single crystal boule 10 is defined on the basis of the following expression (2).

[Math. 2]

$$D_b = 2 \times (D_w + l)cos\frac{\pi}{4} + D_w \quad \cdots (2)$$

In expression (2), $D_b$ is a diameter required for the SiC single crystal boule 10, $D_w$ is a diameter of the SiC substrate, and l is a processing loss width. The processing loss width is at least about 0.1 mm and at most about 0.6 mm. The diameter of the SiC substrate is substantially the same as the diameter of the SiC ingot 20.

For example, a case in which four 4-inch SiC substrates are obtained from the same plane of the SiC single crystal boule 10 is considered.

[Table 3]

| Substrate diameter $D_w$ (mm) | 98.0 | 100.2 | 102.0 |
|---|---|---|---|
| Processing loss l (mm) | 0.1 | 0.3 | 0.6 |
| Boule diameter $D_b$ (mm) | 236.73 | 242.33 | 247.10 |

Table 3 shows results in which the required diameter $D_b$ of the SiC single crystal boule 10 is determined by varying the diameter $D_w$ and a size of the processing loss 1. When four 4-inch substrates are obtained from the same plane of the SiC single crystal boule 10, the required diameter $D_b$ of the SiC single crystal boule 10 is 236 mm or more and 248 mm or less. The diameter Db is preferably between 236.73 mm or more and 247.10 mm or less. If the SiC single crystal boule 10 includes a portion in which the line segment L1 has a length of 236 mm or more and 248 mm or less, four SiC ingots 20 can be obtained from one SiC single crystal boule 10. Also, if an allowable range for the diameter $D_w$ of the 4-inch substrate is 99.5 mm or more and 100.6 mm or less, the required diameter $D_b$ of the SiC single crystal boule 10 is 240 mm or more and 244 mm or less. In this case, if the SiC single crystal boule 10 includes a portion in which the line segment L1 has a length of 240 mm or more and 244 mm or less, four SiC ingots 20 can be obtained from one SiC single crystal boule 10.

Similarly, a case in which four 6-inch substrates are obtained from the same plane of the SiC single crystal boule 10 is considered.

[Table 4]

| Substrate diameter $D_w$ (mm) | 148.0 | 150.2 | 152.0 |
|---|---|---|---|
| Processing loss l (mm) | 0.1 | 0.3 | 0.6 |
| Boule diameter $D_b$ (mm) | 357.45 | 363.04 | 367.81 |

Table 4 shows results in which the required diameter $D_b$ of the SiC single crystal boule 10 is determined by varying the diameter $D_w$ and a size of the processing loss 1. When four 6-inch substrates are obtained from the same plane of the SiC single crystal boule 10, the required diameter $D_b$ of the SiC single crystal boule 10 is 357 mm or more and 368 mm or less. The diameter Db is preferably between 357.45 mm or more and 367.81 mm or less. If the SiC single crystal boule 10 includes a portion in which the line segment L1 has a length of 357 mm or more and 368 mm or less, four SiC ingots 20 can be obtained from one SiC single crystal boule 10. Also, if an allowable range for the diameter $D_w$ of the 6-inch substrate is 149.5 mm or more and 150.6 mm or less, the required diameter $D_b$ of the SiC single crystal boule 10 is 361 mm or more and 365 mm or less. In this case, if the SiC single crystal boule 10 includes a portion in which the line segment L1 has a length of 361 mm or more and 365 mm or less, four SiC ingots 20 can be obtained from one SiC single crystal boule 10.

The SiC single crystal boule 10 according to the present embodiment has a large diameter and can produce a plurality of SiC ingots 20. Also, when the length of the line segment L 1 passing through the center C of the SiC single crystal boule 10 is defined, the loss when the plurality of SiC ingots 20 are obtained can be reduced. Also, since a plurality of SiC substrates can be obtained from each of the SiC ingots 20, a large number of the SiC substrates can be efficiently obtained from the SiC single crystal boule 10 according to the present embodiment.

Next, a manufacturing method of the SiC single crystal boule 10 according to the present embodiment will be described. The manufacturing method of the SiC single crystal boule 10 according to the present embodiment includes a crystal growth step of growing a SiC single crystal on a first surface of a seed crystal using a sublimation method.

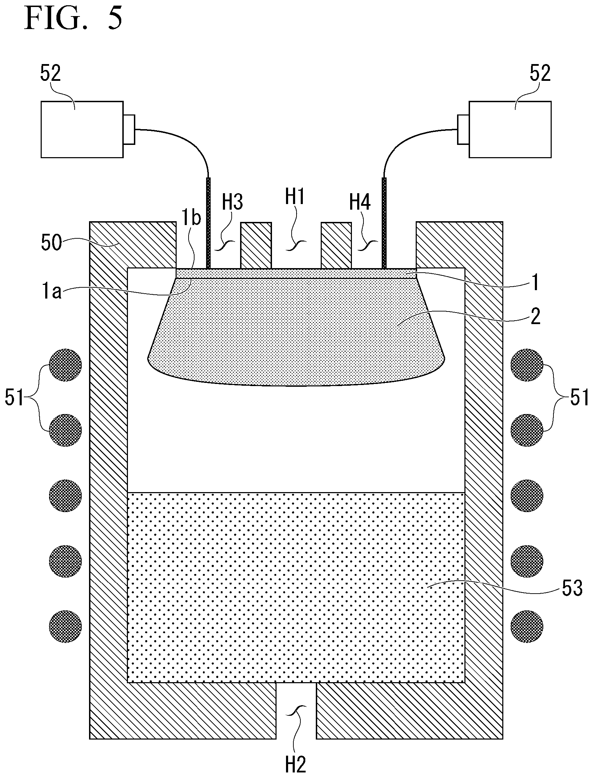

FIG. 5 is a view for explaining a manufacturing method of the SiC single crystal boule 10 according to the present embodiment. An apparatus for manufacturing the SiC single crystal boule 10 includes a crucible 50, a coil 51, and a heating laser 52. The crucible 50 is provided with openings H1 and H2 for temperature measurement and openings H3 and H4 for laser heating.

A raw material powder 53 is filled into the crucible 50. The raw material powder is made of SiC. The seed crystal 1 is placed at a position facing the raw material powder 53 inside the crucible 50. When a current is caused to flow through the coil 51 surrounding a circumference of the crucible 50, the raw material powder 53 inside the crucible 50 is heated. A gas sublimated from the raw material powder 53 recrystallizes on a first surface 1a of the seed crystal 1, and the crystal growth portion 2 formed of the SiC single crystal grows on the first surface 1a.

In the crystal growth step, a second surface 1b of the seed crystal 1 is irradiated with laser. The second surface 1b is a surface facing the first surface 1a of the seed crystal 1. The laser is emitted from the heating laser 52 through the openings H3 and H4. The heating laser 52 is, for example, a $CO_2$ laser with a wavelength of 10600 nm. The heating laser 52 heats, for example, two positions that are symmetrical with respect to a center of the seed crystal 1. An output of the heating laser 52 is, for example, tens of watts.

In the crystal growth step, the seed crystal 1 rotates together with the crucible 50. As the seed crystal 1 rotates, the heating laser 52 heats the seed crystal 1 uniformly in a circumferential direction. A rotation speed of the seed crystal 1 is, for example, 6 rpm.

The heating laser 52 can change a laser irradiation position in a radial direction of the seed crystal 1. A heating position of the seed crystal 1 by the laser can be changed in the radial direction. When the heating position of the seed crystal 1 is changed, a temperature distribution on a crystal growth surface of the crystal growth portion 2 can be controlled.

In the crystal growth step, a temperature at the laser irradiation position is controlled to be within ±5°C of a temperature at the center of the seed crystal 1 in the radial direction. The temperature can be measured using, for example, a High-end research thermography FLIR A6000 series/X6000 series manufactured by Chino Corporation. This temperature control is performed, for example, by adjusting an output of the heating laser 52 and the heating position as required.

For example, in an initial stage of crystal growth, a temperature in the vicinity of a circumference of the seed crystal 1 is often lower than the temperature at the center. Therefore, in the initial stage of the crystal growth, high-output laser is emitted to the vicinity of the outer circumference of the seed crystal 1. Since the outer circumferential portion of the seed crystal 1 and the crystal growth portion 2 is heated by the laser irradiation, a temperature difference between the vicinity of the outer circumference and the center of the seed crystal 1 becomes smaller in the middle and final stages of the crystal growth. In this case, when the laser output is reduced as the crystal growth progresses, the temperature distribution on the crystal growth surface of the crystal growth portion 2 becomes smaller. Also, at the same time, the heating position by the laser is moved from the vicinity of the outer circumference toward the center as the crystal growth progresses. For example, the heating position of the laser is moved at 0.25 mm/h. For example, the heating position of the laser is moved 35 mm toward the center of the seed crystal 1 from the beginning to the end of the growth.

When the SiC single crystal boule 10 is produced according to the above-described procedure, a large-diameter SiC single crystal boule 10 can be produced. It is believed that, by controlling the temperature distribution on the crystal growth surface of the SiC single crystal boule 10, a stress occurring within the SiC single crystal boule 10 can be reduced, and the SiC single crystal boule will not crack even if it has a large diameter.

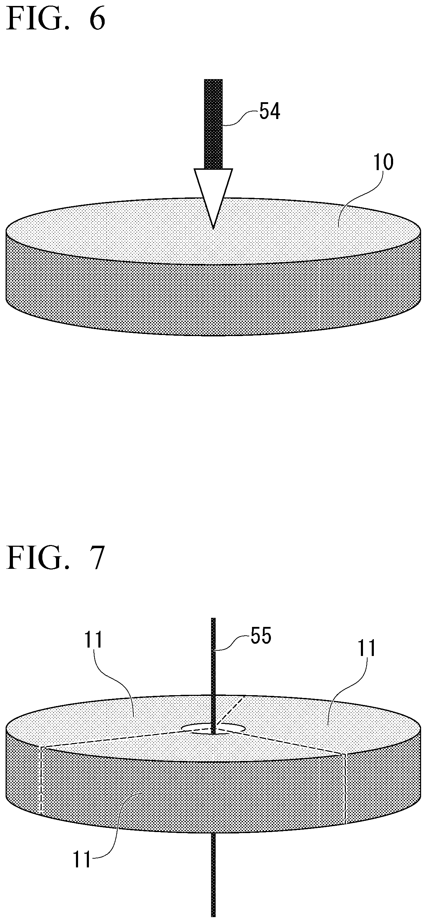

Next, a method of producing a SiC substrate from the produced SiC single crystal boule 10 will be described. The manufacturing method of the SiC substrate according to the present embodiment includes an opening forming step, a dividing step, an ingot processing step, and a slicing step. FIGS. 6 to 9 are views for explaining the manufacturing method of the SiC substrate according to a first embodiment.

FIG. 6 is a schematic view for explaining the opening forming step. In the opening forming step, an opening is formed at a center of the large-diameter SiC single crystal boule 10 produced by the procedure described above. The opening is made using a drill 54 coated with, for example, a boron nitride (BN) or diamond. A diameter of the opening is 7 mm or less and is, for example 2 mm. The drill 54 is, for example, a UDCMX manufactured by UNION TOOL CO.

FIG. 7 is a schematic view for explaining the dividing step. In the dividing step, the SiC single crystal boule 10 is cut radially outward from the opening to divide the SiC single crystal boule 10 into a plurality of parts 11. In the dividing step, a wire 55 is passed through the opening and cuts the SiC single crystal boule 10 outward from the inside. When the SiC single crystal boule 10 is cut outward from the inside, occurrence of cracks can be suppressed more effectively than when the SiC single crystal boule 10 is cut from the outside toward the inside.

The division is preferably performed using, for example, a free-abrasive cutting machine. The free-abrasive cutting machine can reduce loss during cutting compared to a fixed-abrasive cutting machine. The slurry used can use a commercially available one. A diameter of the wire 55 is, for example, 0.15 mm. When the diameter of the wire 55 is reduced, loss during cutting can be reduced.

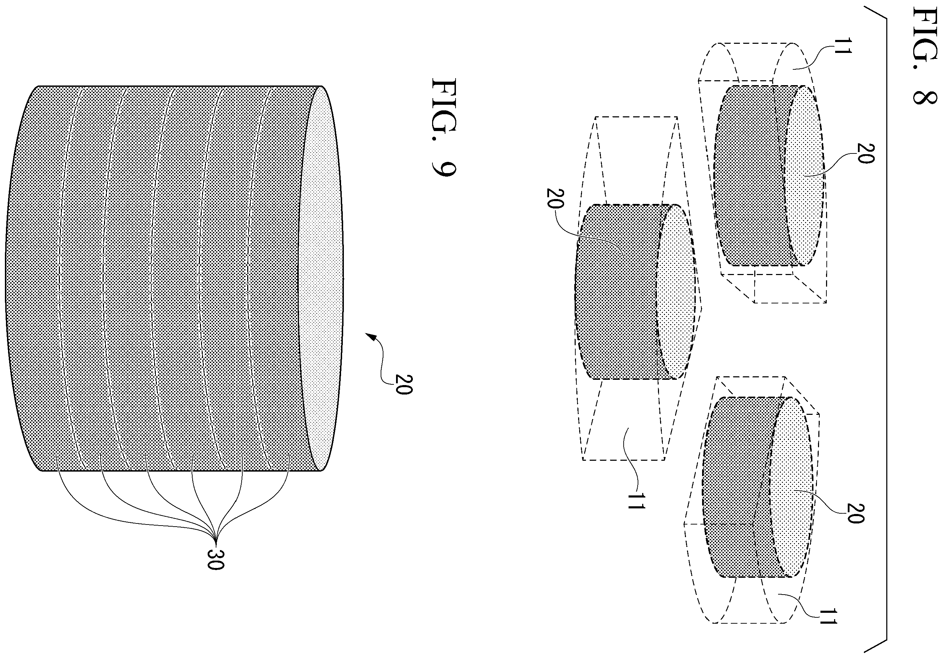

FIG. 8 is a schematic view for explaining the ingot processing step. In the ingot processing step, each of the plurality of parts 11 cut in the dividing step is processed into the SiC ingot 20. The processing for producing the SiC ingot 20 can be performed using a cylindrical grinding machine.

FIG. 9 is a schematic view for explaining the slicing step. In the slicing step, each of the SiC ingots 20 is sliced. The slicing may be performed using a laser, a wire saw, or the like. A plurality of SiC substrates 30 are obtained from each of the SiC ingots 20. The SiC substrate 30 may be polished on both sides.

In the manufacturing method of the SiC substrate according to the present embodiment, the SiC single crystal boule 10 is divided outward from the inside. Cutting the SiC single crystal boule 10 from the outside increases a risk of cracks, but when the SiC single crystal boule 10 is divided outward from the inside, the risk of cracks is reduced.

Although the preferred embodiment of the present disclosure has been described in detail, the present disclosure is not limited to the specific embodiment, and various modifications and changes can be made within the range of the gist of the present disclosure described in the claims.

EXPLANATION OF REFERENCES

1 Seed crystal
1a First surface
1b Second surface
2 Crystal growth portion
10 SiC single crystal boule
20 SiC ingot
30 SiC substrate
50 Crucible
51 Coil
52 Heating laser
53 Raw material powder
54 Drill
55 Wire
H1, H2, H3, H4 Opening

## Claims

1. A SiC single crystal boule comprising a portion in a cross section orthogonal to a crystal growth direction in which a line segment passing through a center of a largest inscribed circle contained within the cross section and connecting a first outer circumferential point and a second outer circumferential point of the cross section has a predetermined length, and
wherein the predetermined length is any one of 211 mm or more and 221 mm or less, 236 mm or more and 248 mm or less, 319 mm or more and 329 mm or less, and 357 mm or more and 368 mm or less.

2. The SiC single crystal boule according to claim 1, wherein the predetermined length is 211 mm or more and 221 mm or less.

3. The SiC single crystal boule according to claim 2, wherein the predetermined length is 214 mm or more and 218 mm or less.

4. The SiC single crystal boule according to claim 1, wherein the predetermined length is 236 mm or more and 248 mm or less.

5. The SiC single crystal boule according to claim 4, wherein the predetermined length is 240 mm or more and 244 mm or less.

6. The SiC single crystal boule according to claim 1, wherein the predetermined length is 319 mm or more and 329 mm or less.

7. The SiC single crystal boule according to claim 6, wherein the predetermined length is 322 mm or more and 326 mm or less.

8. The SiC single crystal boule according to claim 1, wherein the predetermined length is 357 mm or more and 368 mm or less.

9. The SiC single crystal boule according to claim 8, wherein the predetermined length is 361 mm or more and 365 mm or less.

10. A manufacturing method of a SiC single crystal boule comprising a crystal growth step of growing a SiC single crystal on a first surface of a seed crystal using a sublimation method, wherein

   laser is emitted onto a second surface of the seed crystal on a side opposite to the first surface while the seed crystal is rotated in the crystal growth step, and
   a temperature of a laser irradiation position is controlled to be within ±5°C of a temperature at a center of the seed crystal in a radial direction.

11. A manufacturing method of a SiC substrate comprising:

   a step of forming an opening at a center of the SiC single crystal boule according to any one of claims 1 to 9;
   a step of cutting the SiC single crystal boule radially outward from the opening and dividing the SiC single crystal boule into a plurality of parts; and
   a step of processing each of the plurality of parts into a SiC ingot and slicing the SiC ingot.

# FIG. 1

# FIG. 2

FIG. 3

FIG. 4

FIG. 5

FIG. 6

FIG. 7

FIG. 8

FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002075923 A